# EUROPÄISCHE PATENTSCHRIFT

(11) **EP 0 377 066 B1**
(45) Veröffentlichungstag und Bekanntmachung des Hinweises auf die Patenterteilung: **27.04.1994**
(21) Anmeldenummer: 89100170.3
(22) Anmeldetag: 05.01.1989
(51) Int. Cl.: H05K 5/02

(54) **Einrichtung zur Be- und Entlüftung von Gehäusen**
Device for aerating of casings
Dispositif pour l'aération des coffrets

(43) Veröffentlichungstag der Anmeldung: 11.07.1990
(73) Patentinhaber: W.L. Gore & Associates GmbH, 85636 Putzbrunn (DE)
(72) Erfinder: Hofner, Harald, D-8000 München 71 (DE); Kleis, Rudolf, D-8151 Feldkirchen (DE)
(74) Vertreter: Klunker . Schmitt-Nilson . Hirsch

(56) Entgegenhaltungen:
- WO-A-88/09422
- DE-U- 8 801 177

## Beschreibung

Die Erfindung betrifft eine Einrichtung zur Be- und Entlüftung von Gehäusen.

In einer speziellen Anwendung bezieht sich die Erfindung auf Be- und Entlüftungen von Gehäusen für elektrische Schaltungen, Elektromotoren oder andere Bauteile in einem Kraftfahrzeug. Grundsätzlich bezieht sich die Erfindung aber auch auf als Behälter ausgebildete Gehäuse. Bei Behältern für Flüssigkeiten muß häufig eine Entlüftung vorgesehen sein, wobei jedoch das Erfordernis besteht, daß keine Flüssigkeit durch die Entlüftung hindurch gelangen darf. Speziell für Behälter wurden hierzu schon Verschlüsse mit einer eingebauten flachen Membran aus porösem PTFE vorgeschlagen, siehe z.B. DE-U-8 801 177.

Auch bei Gehäusen für Elektromotoren und elektrische Baugruppen muß für eine Belüftung gesorgt werden, wobei speziell bei der Verwendung in Kraftfahrzeugen das Erfordernis besteht, daß die Entlüftung für das Gehäuse lageunabhängig funktionieren sollte, damit beim Einbau des Gehäuses in das Kraftfahrzeug jede Einbaulage möglich ist. Man kann daran denken, an einem Gehäuse eine Öffnung mit einem Stutzen vorzusehen, um den Stutzen mit einem eine flache Mambran enthaltenden Stöpsel zu verschließen. Diese Membran besteht zum Beispiel aus porösem PTFE und gewährleistet, daß zwar Luft durch die Membran hindurchtreten kann, nicht jedoch Flüssigkeit. Derartige Entlüftungen erfüllen ihren Zweck gut, solange die Membran derart orientiert ist, daß sich auf ihr kein Wasser, zum Beispiel Kondens- oder Spritzwasser, sammeln kann. Sammelt sich nämlich auf der flachen Membran Wasser, so kann keine Luft mehr durch die Membran hindurchtreten. Bislang wurden die Belüftungseinrichtungen an den Gehäusen deshalb an einer Stelle angebracht, an der die Membran eine etwa vertikale Lage einnahm. Nachteilig bei dieser Lösung ist es jedoch, daß dadurch nur eine gewisse Anzahl von Möglichkeiten für den Einbau des Gehäuses gegeben ist.

Aufgabe der Erfindung ist es, eine Gehäusebe- und entlüftungseinrichtung zu schaffen, die in jeder beliebigen Lage und Orientierung des Gehäuses funktioniert.

Gelöst wird diese Aufgabe durch ein gasdurchlässiges wasserundurchlässiges Schlauchmembranstück, das mit mindestens einem Ende mit einer Gehäuseöffnung verbunden ist.

Das Schlauchmembranstück verschließt eine Öffnung des Gehäuses wasserdicht, so daß kein Wasser aus dem Geäuse heraus und in das Gehäuse hineingelangen kann, während aufgrund der Gasdurchlässigkeit eine Belüftung und Entlüftung des Gehäuses erfolgt. Aufgrund der schlauchförmigen Membran wird erreicht, daß unabhängig von der Lage des Gehäuses sich niemals auf der gesamten Oberfläche der porösen Membran die Gasdurchlässigkeit beeinträchtigendes oder gar beseitigendes Wasser ansammeln kann. Kondenswasser oder Spritzwasser läuft stets an der Außenseite des Schlauchstücks ab, so daß die Oberfläche des Schlauchstücks für den Gasdurchtritt frei bleibt. Dieser Vorteil ist besonders interessant bei Gehäusen für Elektromotoren, elektrische Schaltungen oder dergleichen, wie sie in Kraftfahrzeugen eingesetzt werden.

In einer besonderen Ausbildung ist die Gehäuseöffnung als Stutzen ausgebildet, der vorzugsweise in das Gehäuseinnere gerichtet ist, grundsätzlich aber auch auf der Außenseite des Gehäuses liegen kann. Auf den Stutzen wird einfach ein Schlauchmembranstück, zum Beispiel ein Stück PTFE-Schlauch aufgesteckt. Das freie Ende des Schlauchs wird mit einem Verschluß versehen, wobei es sich zum Beispiel um einen angeschweißten Stöpsel handeln kann. Man kann das freie Ende des PTFE-Schlauchs auch zusammenkneifen und verschweißen.

In einer speziellen Ausführungsform befinden sich an dem Gehäuse zwei Stutzen, auf denen jeweils ein Ende eines Schlauchmembranstücks sitzt.

Insbesondere bei der Ausführungsform mit nur einem einzigen Stutzen am Gehäuse empfiehlt es sich, das Schlauchmembranstück nicht direkt auf den Stutzen aufzuschieben, sondern das Schlauchmembranstück auf einem siebartigen Stützträger zu befestigen, um den Stützträger dann an dem Stutzen des Gehäuses zu befestigen. Bei dem Siebträger kann es sich zum Beispiel um ein kleines Rohr aus gelochtem Blech oder vorzugsweise aus Metallgeflecht handeln.

Gemäß einer weiteren Ausführungsform der Erfindung ist der Stützträger ein perforiertes Metall- oder Siebrohr. Auf das Rohr ist ein Schlauchmembranstück aufgesteckt und das Rohr hat eine solche Länge, daß es das Gehäuse vollständig durchsetzt und in zwei verschiedenen Gehäusewandungen mündet. Eine solche Entlüftungsanordnung kann in jeder beliebigen Lage montiert werden, da der Entlüftungsmechanismus lageunabhängig funktioniert. Das Entlüftungsrohr braucht nicht unbedingt achssymmetrisch in dem Gehäuse angeordnet sein, sondern kann auch in einem Winkel zu den Gehäusewandungen verlaufen, wichtig ist lediglich, daß das Rohr an zwei unterschiedlichen Gehäusewandungen mündet

Im folgenden werden Ausführungsbeispiele der Erfindung anhand der Zeichnung näher erläutert. Es zeigen:
- Fig. 1: eine Seitenansicht eines Gehäuses mit einer Gehäusebe- und entlüftungseinrichtung,
- Fig. 2: eine Längsschnittansicht der Be- und entlüftungseinrichtung bei dem Gehäuse nach Fig. 1,
- Fig. 3: eine Seitenansicht einer weiteren Ausführungsform eines Gehäuses mit Be- und entlüftungseinrichtung,
- Fig. 4: eine teilweise geschnittene Darstellung einer dritten Ausführungsform einer Gehäusebe- und entlüftungseinrichtung,
- Fig. 5a, 5b: ein Gehäuse mit außen liegendem Stutzen, wobei auf den radial durchlöcherten Stutzen ein am freien Ende geschlossenes Schlauchmembranstück aufgezogen ist,
- Fig. 6: die perspektivische Abbildung eines Gehäuses mit durchlaufendem Entlüftungsrohr, und
- Fig. 7: eine Entlüftungsanordnung bestehend aus einem teilweise aus dem Schlauchmembranstück herausgezogenen Stützträger in Form eines perforierten Rohres.

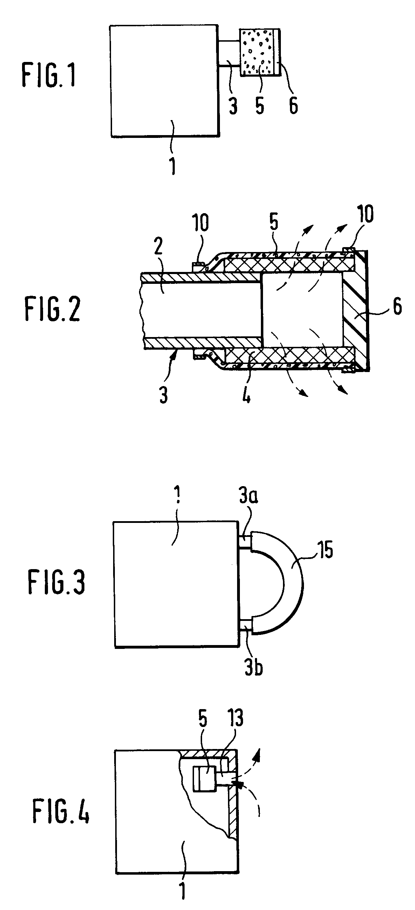

Bei einem in Fig. 1 schematisch dargestellten Gehäuse 1 handelt es sich zum Beispiel um das Gehäuse eines Elektromotors, zum Beispiel eines Fensterhebermotors, für ein Kraftfahrzeug. An der Außenseite des Gehäuses 1 befindet sich ein Rohrstutzen 3, auf den ein aus porösem Polytetrafluorethylen (PTFE) bestehendes Schlauchmembranstück 5 aufgeschoben ist. Das äußere Ende des Schlauchmembranstücks 5 ist mit einem Stöpsel 6 aus Kunststoff verschlossen.

Fig. 2 zeigt in einer Schnittdarstellung die Einzelheiten der in Fig. 1 dargestellten Be- und Entlüftungseinrichtung für das Gehäuse 1. Nach Fig. 2 bildet der Rohrstutzen 3 eine Gehäuseöffnung 2, durch die Luft in das Gehäuse hinein- und aus dem Gehäuse herausgelangen kann. Auf dem Rohrstutzen 3 sitzt ein Rohrstück 4 aus einem Metallgeflecht. Das Rohrstück 4 aus Metallgeflecht ist relativ steif, so daß es sich auch bei mechanischer Beanspruchung nicht leicht verformt. Das Röhrchen 4 aus Metallgeflecht trägt das Schlauchmembranstück 5. An der äußeren Stirnseite liegt ein Innenrand des Stöpsels 6 an. Der Stöpsel ist beispielsweise auf die Stirnseite des Metallgeflecht-Röhrchens 4 und des Schlauchmembranstücks 5 aufgeschweißt. Wie durch gestrichelte Pfeile angedeutet, kann Luft durch das Metallgeflecht des Röhrchens 4 und das poröse PTFE-Material des Schlauchmembranstücks 5 hindurchtreten. Das Schlauchmembranstück 5 wird auf dem Stutzen durch beispielweise eine Rohrschelle 10 dichtend festgehalten.

Die in Fig. 3 dargestellte Ausführungsform der Erfindung benötigt keinen Verschlußstöpsel. Am Gehäuse befinden sich zwei Stutzen 3a und 3b, auf die jeweils ein Ende eines Schlauchmembranstücks 15 aufgesteckt ist. Bei dieser Ausführungsform ist das ebenfalls aus porösem PTFE bestehende Schlauchmembranstück 15 auf die Stutzen aufgesteckt. Ein Träger aus beispielsweise Metallgeflecht ist nicht unbedingt erforderlich.

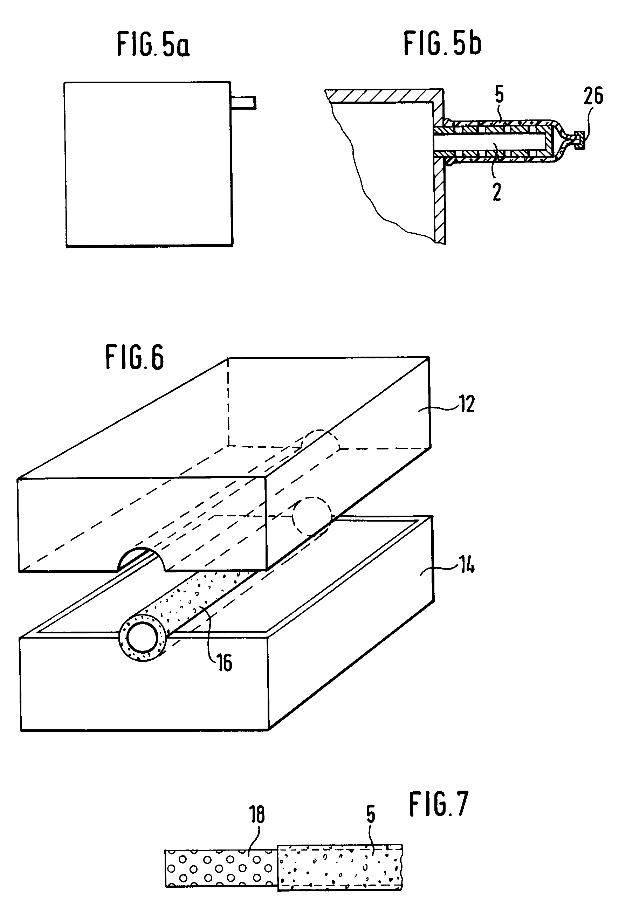

Die Ausführungsform nach Fig. 4 entspricht derjenigen nach Fig. 1, wobei sich jedoch im Inneren des Gehäuses 1 ein Stutzen 13 befindet, der das Schlauchmembranstück trägt.

In der Fig. 5a ist die Ansicht eines Behälters mit außen angebrachtem Stutzen gezeigt, ein Schnitt durch den Stutzen in vergrößertem Maßstab zeigt die Fig. 5b. Der an seiner Stirnseite geschlossene Stutzen 2 weist radiale Perforationslöcher auf. Über den Stutzen ist ein Schlauchmembranstück 5 gezogen, das am Stutzensockel durch beispielsweise eine Rohrschelle befestigt ist und dessen freies Ende durch eine Klammer oder auch eine Schweißnaht 26 verschlossen ist. Die Ausführungsform nach Fig. 4 funktioniert nicht lageunabhängig. Der Behälter muß so montiert bzw. aufgestellt werden, daß nicht der Stutzen voll Wasser lauft. Üblicherweise wird bei nach außen ragenden Stutzen über die Membran noch eine poröse Schutzhülse bzw. -schicht angeordnet, damit die Membran mechanisch geschützt ist und nicht verschmutzt.

Eine lageunabhängig funktionierende Einrichtung ist in Fig. 6 dargestellt. Die beiden Gehäusehälften 12 und 14 umschließen dichtend ein gerades Rohrstück 16, das beispielsweise aus einem gelochten Metallrohr 18 mit darüber gezogenem Schlauchmembranstück 5 besteht. Der Aufbau des Entlüftungsrohres ist in Fig. 7 nochmals dargestellt, wobei der Stutzträger 18 teilweise aus dem Schlauchmembranstück 5 herausgezogen ist.

Das Entlüftungsrohr 16 wird in eine Gehäusehalfte 14 eingelegt und das Gehäuse durch Auflegen der zweiten Hälfte 12 geschlossen. Die Gehäusedurchbrechungen sind so dimensioniert, daß die Schlauchmembran im Bereich der Wanddurchbrechungen als Dichtmaterial wirkt. Unabhängig von der Lage des Gehäuses findet immer eine Be- bzw. Entlüftung des Gehäuses im Inneren statt. Das sich im Inneren sammelnde Kondenswasser kann niemals die gesamte Membranoberfläche benetzen.

## Patentansprüche

1. Einrichtung zur Be- und Entlüftung von Gehäusen, gekennzeichnet durch ein gasdurchlässiges, wasserundurchlässiges Schlauchmembranstück (5; 15; 25), das mit mindestens einem Ende mit einer Gehäuseöffnung (2) verbunden ist.

2. Einrichtung nach Anspruch 1, dadurch gekennzeichnet, daß das Gehäuse (1) zur Aufnahme von feuchtigkeitsempfindlichen Elementen, wie elektrischen oder elektronischen Bauteilen dient.

3. Einrichtung nach Anspruch 2, dadurch gekennzeichnet, daß das Gehäuse (1) zur Aufnahme eines Elektromotors oder einer elektrischen Schaltung in einem Kraftfahrzeug dient.

4. Einrichtung nach Anspruch 1, dadurch gekennzeichnet, daß die Gehäuseöffnung als Stutzen (3; 3a, 3b; 13) ausgebildet ist.

5. Einrichtung nach einem der Ansprüche 1 bis 4, dadurch gekennzeichnet, daß der Stutzen (3; 3a, 3b) in das Gehäuseinnere ragt und ein aufgestecktes Ende des Schlauchmembranstücks (5; 15) trägt.

6. Einrichtung nach Anspruch 5, dadurch gekennzeichnet, daß das freie Ende des Schlauchmembranstücks mit einem Verschluß (6; 26) versehen ist.

7. Einrichtung nach einem der Ansprüche 1-5, dadurch gekennzeichnet, daß zwei, insbesondere außen am Gehäuse (1) vorgesehene Stutzen (3a, 3b) je ein Ende des Schlauchmembranstücks (15) aufweisen.

8. Einrichtung nach einem der Ansprühce 1-7, dadurch gekennzeichnet, daß das Schlauchmembranstück (5) auf einem siebartigen Stützträger (4) sitzt.

9. Einrichtung nach Anspruch 8, dadurch gekennzeichnet, daß der Stützträger rohrförmig ist.

10. Einrichtung nach Anspruch 9, dadurch gekennzeichnet, daß der Stützträger aus einem perforierten Metall-oder Kunststoffrohr besteht.

11. Einrichtung nach Anspruch 10, dadurch gekennzeichnet, daß der Stützträger mit aufgeschobener Membran ein gerades Rohr ist, das das Gehäuse durchsetzt und in zwei verschiedenen Gehäusewänden mündet.

12. Einrichtung nach Anspruch 11, dadurch gekennzeichnet, daß die den Stützträger umgebende Membran im Bereich der Durchführung durch die Gehäusewandung als Dichtung wirkt.

13. Einrichtung nach einem der Ansprüche 1-12, dadurch gekennzeichnet, daß das Schlauchmembranstück aus porösem PTFE besteht.

## Claims

1. A device for airing and deairing housings, characterized by a piece of gas-permeable, waterproof tubular membrane (5; 15; 25) with at least one end connected with a housing opening (2).

2. The device of claim 1, characterized in that the housing (1) serves to take up moisture-sensitive elements such as electric or electronic components.

3. The device of claim 2, characterized in that the housing (1) serves to take up an electric motor or an electric circuit in a motor vehicle.

4. The device of claim 1, characterized in that the housing opening is formed as a socket piece (3; 3a, 3b; 13).

5. The device of any of claims 1 to 4, characterized in that the socket piece (3; 3a, 3b) protrudes into the interior of the housing and bears a slipped-on end of the piece of tubular membrane (5; 15).

6. The device of claim 5, characterized in that the free end of the piece of tubular membrane is provided with sealing means (6; 26).

7. The device of any of claims 1-5, characterized in that two socket pieces (3a, 3b) provided in particular on the outside of the housing (1) each bear an end of the piece of tubular membrane (15).

8. The device of any of claims 1-7, characterized in that the piece of tubular membrane (5) is seated on a sievelike carrier support (4).

9. The device of claim 8, characterized in that the carrier support is tubular.

10. The device of claim 9, characterized in that the carrier support consists of a perforated metal or plastic pipe.

11. The device of claim 10, characterized in that the carrier support with the slipped-on membrane is a straight pipe that penetrates the housing and opens into two different housing walls.

12. The device of claim 11, characterized in that the membrane surrounding the carrier support acts as a seal in the area of passage through the housing wall.

13. The device of any of claims 1-12, characterized in that the piece of tubular membrane is made of porous PTFE.

## Revendications

1. Dispositif pour l'aération de coffrets, caractérisé par une pièce de membrane en forme de tuyau (5 ; 15 ; 25) perméable aux gaz et imperméable à l'eau, ladite pièce étant reliée par l'une au moins de ses extrémités à une ouverture (2) du coffret.

2. Dispositif selon la revendication 1, caractérisé en ce que le coffret (1) sert à recevoir des éléments sensibles à l'humidité, comme par exemple des composants électriques ou électroniques.

3. Dispositif selon la revendication 2, caractérisé en ce que le coffret (1) sert à recevoir un moteur électrique ou un circuit électrique dans un véhicule automobile.

4. Dispositif selon la revendication 1, caractérisé en ce que l'ouverture du coffret est réalisée sous la forme d'un manchon (3 ; 3a, 3b ; 13).

5. Dispositif selon l'une quelconque des revendications 1 à 4, caractérisé en ce que le manchon (3 ; 3a, 3b) pénètre à l'intérieur du coffret et porte une extrémité enfilée de la pièce de membrane (5 ; 15).

6. Dispositif selon la revendication 5, caractérisé en ce que l'extrémité libre de la pièce de membrane est pourvue d'une obturation (6 ; 26).

7. Dispositif selon l'une quelconque des revendications 1 à 5, caractérisé en ce qu'il est prévu deux manchons (3a, 3b) sur le coffret et en particulier à l'extérieur, qui portent chacun une extrémité de la pièce de membrane (15).

8. Dispositif selon l'une quelconque des revendications 1 à 7, caractérisé en ce que la pièce de membrane (5) est montée sur un support (4) en forme de tamis.

9. Dispositif selon la revendication 8, caractérisé en ce que le support a une forme tubulaire.

10. Dispositif selon la revendication 9, caractérisé en ce que le support est réalisé en un tube perforé en métal ou en matière plastique.

11. Dispositif selon la revendication 10, caractérisé en ce que le support avec la membrane enfilée est un tube droit qui traverse le coffret et qui débouche dans deux parois différentes du coffret.

12. Dispositif selon la revendication 11, caractérisé en ce que la membrane qui entoure le support agit en tant qu'étanchéité dans la région de la traversée de la paroi du coffret.

13. Dispositif selon l'une quelconque des revendications 1 à 12, caractérisé en ce que la pièce de membrane est réalisée en polytétrafluoroéthylène (PTFE) poreux.
